# EUROPÄISCHE PATENTSCHRIFT

(11) **EP 2 100 851 B1**
(45) Veröffentlichungstag und Bekanntmachung des Hinweises auf die Patenterteilung: **14.08.2013**
(21) Anmeldenummer: 09003464.6
(22) Anmeldetag: 10.03.2009
(51) Int. Cl.: C01B 33/035, G05D 23/19

(54) **Vorrichtung und Verfahren zur Erzeugung einer gleichmäßigen Temperaturverteilung in Siliziumstäben während eines Abschiedeverfahrens**
Device and method for creating an equal temperature distribution in silicon rods during a separation method
Dispositif et procédé de production d'une répartition régulière de température dans des tiges de silicium lors d'un procédé de séparation

(30) Priorität: 10.03.2008 DE 202008003991 U; 27.08.2008 DE 102008039958; 26.02.2009 EP 09002710
(43) Veröffentlichungstag der Anmeldung: 16.09.2009
(73) Patentinhaber: AEG Power Solutions B.V., 1161 AH Zwanenburg (NL)
(72) Erfinder: Wallmeier, Peter Dr., 59556 Lippstadt (DE)
(74) Vertreter: Brune, Axel

(56) Entgegenhaltungen:
- WO-A-97/36822
- DE-T0- 19 882 883
- US-A- 3 232 792

## Beschreibung

Die vorliegende Erfindung betrifft eine Vorrichtung zur Stromversorgung wenigstens eines Siliziumstabs während des Abscheidens von Silizium nach dem Siemens-Verfahren. Die Erfindung betrifft ferner ein Verfahren zur Stromversorgung wenigstens eines Siliziumstabs während des Abscheidens von Silizium nach dem Siemens-Verfahren mit einer solchen Vorrichtung.

Vorrichtungen zur Stromversorgung eines Siliziumstabs während des Abscheidens von Silizium nach dem Siemens-Verfahren sind aus dem Stand der Technik bekannt. Derartige Vorrichtungen weisen einen Eingang auf, mit dem die Vorrichtung an ein elektrisches Energieversorgungsnetz zur Versorgung mit elektrischer Energie angeschlossen werden kann. Die Vorrichtungen weisen ferner zumindest einen Ausgang auf, an welchen ein oder mehrere Siliziumstäbe angeschlossen werden können. Ein oder mehrere Wechselstromsteller versorgen den oder die an dem Ausgang oder den Ausgängen angeschlossenen Siliziumstab bzw. Stäbe mit elektrischen Strom aus dem Energieversorgungsnetz. Mittels des Wechselstromstellers kann die Stromstärke und die Spannung und somit auch die in dem Siliziumstab thermisch umgesetzte elektrische Leistung eingestellt werden.

Bei der Herstellung von Siliziumstäben nach dem Siemens-Verfahren werden Siliziumstäbe in einem Reaktor mittels der Vorrichtungen mit Strom versorgt. Der Reaktor ist mit Trichlorsilan gefüllt und steht unter Druck. Die in den Siliziumstäben durch den Stromfluss umgesetzte thermische Verlustleistung bewirkt ein Aufheizen der Siliziumstäbe. Die Oberflächentemperatur der Siliziumstäbe erreicht ca. 1.100°C. Bei dieser Temperatur zersetzt sich Trichlorsilan und dissoziiert bei Wasserstoffzugang zu Silizium und Chlorwasserstoff. Das Silizium scheidet sich an dem oder den in den Reaktor befindlichen Siliziumstäben ab. Der Abscheidevorgang lässt den Durchmesser des Siliziumstabs im Laufe des Prozesses um ca. 1 mm/h wachsen. Die Querschnittsfläche des Siliziumstabs vergrößert sich dadurch. Bei gleichbleibenden spezifischen Widerstand des Siliziumstabs führt die größere Querschnittsfläche zu einem abnehmenden elektrischen Widerstand des Stabes. Außerdem verändert sich die Stromdichte von einer über dem Radius konstanten zu einer vom Radius stark abhängigen Größe. Bei Durchmessern der Siliziumstäbe von 7-10mm ist der Widerstand vom Radius unabhängig. Bei größeren Durchmessern ist die Stromdichte im Inneren des Stabes größer als außen.

Da die elektrische Leitfähigkeit von Silizium mit der Temperatur zunimmt und die Wärmeleitfähigkeit des Siliziums mit der Temperatur abnimmt, führt die Einschnürung des Stroms in der Mitte des Stabes zu einem Temperaturgefälle von innen nach außen. Das Temperaturgefälle kann so extrem ausgeprägt sein, dass der Stab innen Temperaturen von größer als 1.460°C erreicht, während die Temperatur auf der Außenseite des Siliziumstabs 1.100°C beträgt. Eine Temperatur von 1.460°C im Kern des Siliziumstabs führt jedoch zu einem Aufschmelzen des Silizium im Kern des Stabes. In der Folge kann das Silizium aus dem Stab herausfließen und der Stab wird zerstört. Die Abscheidetemperatur muss daher so eingestellt werden, dass die Kerntemperatur nicht die Schmelztemperatur von Silizium übersteigt.

Allerdings möchte man die Abscheidetemperatur so groß wie möglich machen, um ein großes Stabwachstum bzw. eine hohe Abscheidegeschwindigkeit zu erreichen.

In der Veröffentlichung mit der Nr. WO 97/36 822 zu einer internationalen Patentanmeldung wird eine Vorrichtung zum Abscheiden von Silizium an Siliziumstäben nach dem Siemens-Verfahren offenbart. Die Veröffentlichung behandelt auch das Problem des Temperaturgefälles zwischen dem Kern und der äußeren Oberfläche des Siliziumstabs. In der Veröffentlichung wird vorgeschlagen, dass eine weitere Heizung vorgesehen wird, die Wirbelströme in dem Siliziumstab erzeugt. Die Wirbelströme erzeugen ein magnetisches Wechselfeld mit einer vorbestimmten Frequenz. Dadurch wird eine Veränderung der Stromdichte erreicht. Die Stromdichte wird von der äußeren Oberfläche des Siliziumstabs zum Kern des Siliziumstabs homogener, so dass eine gleichmäßigere Temperatur zur Verteilung eintritt.

Die in der Veröffentlichung vorgestellte Vorrichtung ist aufwendig, da zusätzlich zu der herkömmlichen Widerstandsheizung zum Erhitzen der Siliziumstäbe eine zweite Heizung, nämlich die Wirbelstromheizung vorgesehen sein muss.

Aus der Veröffentlichung des Deutschen Patent- und Markenamtes unter der Nummer DE 198 82 883 T1 ist eine Vorrichtung bekannt, die den bei hoch- oder mittelfrequenten Strömen in einem Leiter auftretenden Skineffekt nutzt, um eine gleichmäßige Temperaturverteilung innerhalb eines Siliziumstabes zu erreichen. Bei der offenbarten Vorrichtung ist nur eine Heizung vorgesehen, nämlich eine Widerstandsheizung. Diese Widerstandsheizung wird jedoch von Strömen unterschiedlicher Frequenzen in Funktion gesetzt. Nach der technischen Lehre dieser Druckschrift wird zunächst eine niederfrequente Spannung an den Siliziumstab angelegt. Wenn die Temperatur des Siliziumstabes einen vorgegebenen Wert übersteigt, wird die niederfrequente Spannung abgeschaltet und einen Spannung mit einer höheren Frequenz angelegt. Eine Vorrichtung zur Versorgung des Siliziumstabs mit elektrischer Energie ist in der Druckschrift DE 198 82 883 T1 nicht näher beschreiben.

Das aus der Druckschrift DE 198 82 883 T1 bekannte Verfahren die Siliziumstäbe entweder nur mit niederfrequenten Strömen oder nur mit hoch- oder mittelfrequenten Strömen zu versorgen, hat den Nachteil, dass bei der Versorgung des Siliziumstabs nur mit hoch- oder mittelfrequenter Spannung vergleichsweise hohe induktive Verluste auftreten.

Der Erfindung liegt vor dem Hintergrund des zuletzt genannten Standes der Technik das Problem zugrunde, eine Vorrichtung zur Stromversorgung wenigstens eines Siliziumstabs vorzuschlagen, mit der eine homogenere Temperaturverteilung und Stromdichteverteilung in den angeschlossenen Siliziumstäben erreicht wird. Vorteilhaft sollen dabei induktive Verluste möglichst gering gehalten werden.

Diese Aufgabe wird erfindungsgemäß dadurch gelöst, dass die Vorrichtung wenigstens einen Frequenzumrichter aufweist, der zur Versorgung des wenigstens einen an den wenigstens einen Ausgang angeschlossenen Siliziumstabes mit elektrischen Strom aus dem Energieversorgungsnetz geeignet und eingerichtet ist. Der von dem Frequenzumrichter bereitgestellte elektrische Strom hat eine höhere Frequenz als der von dem Wechselstromsteller bereitgestellte Strom. Der höherfrequente Strom wird aufgrund des Skineffekts in die Außenbereiche des Siliziumstabes gedrängt, während der niederfrequentere Strom zu einer hohen Stromdichte im Kern führt. Durch die Überlagerung des höherfrequenten und des niederfrequenten Stroms wird eine insgesamt homogenere Stromdichte erreicht, was zu einer ausgewogeneren Temperaturverteilung über dem Querschnitt des Siliziumstabs führt.

Die erfindungsgemäße Vorrichtung ist so ausgestaltet, dass der Wechselstromsteller und der Frequenzumrichter gleichzeitig eine Spannung an ihren Ausgängen bereitstellen. Diese Spannungen werden in der erfindungsgemäßen Vorrichtung gemischt werden, um am Ausgang der Vorrichtung eine Mischspannung bereitzustellen, die niederfrequente und mittel- oder hochfrequente Anteile enthält. Das Mischen der Ausgangsspannungen des Wechselstromstellers und des Frequenzumrichters erfolgt an einem oder mehreren Knoten, an welchem die beiden Spannungen verknüpft werden.

Gemäß der Erfindung kann ein Ausgang des wenigstens einen Wechselstromstellers, ein Ausgang des wenigstens einen Frequenzumrichters und der Ausgang der Vorrichtung, an den der Siliziumstab angeschlossen ist, elektrisch in Reihe angeordnet sein. D. h. dass der Strom, der von dem Frequenzumrichter bereitgestellt wird, durch den Ausgang des Wechselstromstellers fließt, bevor er über den am Ausgang der Vorrichtung angeschlossenen Siliziumstab fließt. Umgekehrt fließt der Strom, der vom Wechselstromsteller bereitgestellt wird, nachdem er durch den am Ausgang der Vorrichtung angeschlossenen Siliziumstab geflossen ist, über den Frequenzumrichter zurück zum Wechselstromsteller.

Ebenso ist es möglich, dass elektrisch zwischen dem wenigstens einen Wechselstromsteller und dem Ausgang der Vorrichtung ein erstes Mittel zum Entkoppeln (Entkopplungsmittel) des wenigstens einen Wechselstromstellers vom dem wenigstens einen Frequenzumrichter angeordnet ist. Ferner kann zwischen dem wenigstens einen Frequenzumrichter und dem Ausgang der Vorrichtung ein zweites Entkopplungsmittel zum Entkoppeln des wenigstens einen Frequenzumrichters von dem wenigstens einen Wechselstromsteller angeordnet sein. Sind das erste und das zweite Entkopplungsmittel vorgesehen, können die Anordnungen aus dem wenigstens einen Wechselstromsteller und dem ersten Entkopplungsmittel einerseits und dem wenigstens einen Frequenzumrichter und dem zweiten Entkopplungsmittel andererseits bezogen auf den Ausgang elektrisch parallel angeordnet sein. D. h, dass der Strom, der von dem Wechselstromsteller bereitgestellt wird, nicht durch den Ausgang des Frequenzumrichters fließt und ebenso der Strom, der von dem Frequenzumrichter bereitgestellt wird, nicht durch den Ausgang des Wechselstromstellers fließt. Der Wechselstromsteller und der Frequenzumrichter können daher ohne Berücksichtigung des Stroms des jeweils anderen dimensioniert und ausgelegt werden.

In einer bevorzugten Variante einer erfindungsgemäßen Vorrichtung weist diese wenigstens ein Paar von Ausgängen für jeweils einen Siliziumstab und wenigsten ein Paar von Frequenzumrichter auf. Das Paar von Frequenzumrichtern ist dem Paar von Ausgängen zugeordnet. Jeder der beiden Ausgänge eines Paares von Ausgängen kann dann mit einem Ausgang eines Frequenzumrichters des Paar von Frequenzumrichtern verbunden sein. Außerdem können die beiden Frequenzumrichter eines Paares von Frequenzumrichtern zumindest bezüglich ihrer elektrischen Ausgangsgrößen gleich sein. Sofern jeder Frequenzumrichter eines Paares einen Ausgang aufweist und die Ausgänge eines Paares von Frequenzumrichtern eine Kette bilden, in welcher die Ausgänge der Frequenzumrichter gegenphasig verkettet sind, ist es möglich die Ausgänge der Vorrichtung mit den Ausgängen der Frequenzumrichter zu verbinden, wodurch die Ausgänge der Vorrichtung ebenfalls verkettet sind.

Die Kette der Ausgängen der Frequenzumrichter weist dann vorteilhaft einen ersten äußeren Anschluss, einen mittleren Anschluss und einen zweiten äußeren Anschluss auf, wobei der Ausgang eines ersten Frequenzumrichters des Paares von Frequenzumrichtern mit dem erste äußeren Anschluss und dem mittleren Anschluss verbunden ist und der Ausgang eines zweiten Frequenzumrichters des Paares von Frequenzumrichtern mit dem mittleren Anschluss und dem zweiten äußeren Anschluss verbunden ist.

Ferner ist vorteilhaft ein Ausgang des Wechselstromstellers mit dem ersten äußeren Anschluss und dem zweiten äußeren Anschluss verbunden. Die verkettete Spannung aus den Spannungen an den Ausgängen der Frequenzumrichter liegt also am Ausgang des Wechselstromstellers an. Da die Frequenzumrichter bezüglich ihrer Ausgangsgrößen gleich sind, d. h. insbesondere auf gleiche Ausgangspannungen eingestellt sind und die Ausgangspannungen gegenphasig sind, ist die verkette Spannung aus den Spannungen an den Ausgängen der Frequenzumrichter stets null. Am Ausgang des Wechselstromstellers liegt also keine von den Frequenzumrichtern bereitgestellte Spannung an. Der Wechselstromsteller ist somit von den Frequenzumrichtern entkoppelt.

Der erste äußere Anschluss, der mittlere Anschluss und der zweite äußere Anschluss bilden Knoten, an den die niederfrequente Spannung des Wechselstromstellers und die mittel- oder hochfrequenten Spannungen der Frequenzumrichter verknüpft werden.

Eine Entkopplung der Frequenzumrichter von dem Wechselstromsteller kann dagegen dadurch erreicht werden, dass in Reihe zu den Frequenzumrichtern Kondensatoren geschaltet sind, die zusammen mit den an den Ausgängen der Vorrichtung angeschlossenen Siliziumstäben Hochpass-Filter bilden und so Einflüsse vom Wechselstromsteller auch die Frequenzumrichter vermindern oder verhindern.

Gemäß der Erfindung ist der Frequenzumrichter oder sind die Frequenzumrichter vorzugsweise ein Mittelfrequenzumrichter bzw. Mittelfrequenzumrichter. Der wenigstens eine Frequenzumrichter kann geeignet und eingerichtet sein, am Ausgang der Vorrichtung ein Gemisch aus überlagerten Strömen verschiedener Mittelfrequenzen bereitzustellen, die sich gegenseitig überlagern.

Der wenigstens eine Frequenzumrichter einer erfindungsgemäßen Vorrichtung kann ferner zum Einstellen der Frequenz bzw. der Frequenzen des am Ausgang der Vorrichtung bereitgestellten Stroms bzw. bereitgestellten Ströme geeignet und eingerichtet sein.

Jede erfindungsgemäße Vorrichtung kann ein Regelungsmittel aufweisen, das zum Einstellen des Verhältnisses der durch den wenigstens einen Wechselstromsteller zu der durch den wenigstens einen Frequenzumrichter bereitgestellten Leistung geeignet und eingerichtet ist. Da sich während des Abscheidevorgangs der Durchmesser bzw. die Querschnittsfläche des Siliziumstabs verändert, verändert sich auch der elektrische Widerstand des Siliziumstabs. Um trotz der sich ändernden physikalischen Gegebenheiten stets eine optimale Temperaturverteilung innerhalb des Siliziumstabs erreichen zu können, kann die Heizleistung des Wechselstromstellers und des Frequenzumrichters im Verhältnis zueinander geändert werden. Zum Beginn des Abscheidevorgangs kann beispielsweise die Heizleistung des Wechselstromstellers im Verhältnis zu der Heizleistung des Frequenzumrichters größer sein als während eines späteren Zeitpunkts des Abscheideprozesses. Die Vorrichtung kann beispielsweise ein Regelungsmittel aufweisen, dass zum Einstellen der Frequenz bzw. der Frequenzen in Abhängigkeit von dem Durchmesser und/oder der Querschnittsfläche des wenigstens einen Siliziumstabs geeignet und eingerichtet ist.

Der Wechselstromsteller der erfindungsgemäßen Vorrichtung ist vorzugsweise ein netzgeführter Wechselstromsteller.

Eine erfindungsgemäße Versorgung mindestens eines Siliziumstabs mit elektrischem Strom während des Abscheidens von Silizium erfolgt mit einer vorgenannten Vorrichtung. Das erfindungsgemäße Verfahren kann so ausgestaltet sein, dass das Verhältnis der von dem wenigstens einen Wechselstromsteller zur Verfügung gestellte Leistung zu der von dem wenigstens einen Frequenzumrichter zur Verfügung gestellten Leistung während des Abscheideprozesses zum Zweck der Erzeugung einer gleichmäßigen Temperaturverteilung in dem wenigstens einen angeschlossenen Siliziumstab geändert wird. So kann insbesondere die dem wenigstens einen Siliziumstab über dem wenigstens einen Frequenzumrichter zugeführte Leistung im Verhältnis zu der über dem wenigstens einen Wechselstromsteller zugeführte Leistung während des Abscheideprozesses größer werden.

Die Frequenz des Stroms am Ausgang des Wechselstromstellers entspricht im Regelfall der Netzfrequenz des Versorgungsnetzes, an das die erfindungsgemäße Vorrichtung angeschlossen werden kann. Die Frequenz entspricht insbesondere 47 Hz bis 63 Hz. Die Frequenz des Stroms am Ausgang des Frequenzumrichters kann eine Mittelfrequenz von 0,3 MHz bis 300 MHz sein. Vorzugsweise liegt die Frequenz am Ausgang des Frequenzumrichters allerdings im Bereich von 20 kHz bis 200 kHz.

Weitere Merkmale und Vorteile der vorliegenden Erfindung werden deutlich anhand der Zeichnungen. Es zeigt:
- Fig. 1: eine erfindungsgemäße Vorrichtung mit einem Wechselstromsteller und einem Frequenzumrichter, deren Ausgänge in Reihe geschaltet sind,
- Fig. 2: eine erfindungsgemäße Vorrichtung mit einem Wechselstromsteller und einem Frequenzumrichter in Parallelschaltung,
- Fig. 3: eine erfindungsgemäße Vorrichtung mit zwei Frequenzumrichtern mit verketteten Ausgängen,
- Fig. 4: ein Spannungs-Zeit-Diagramm der am Ausgang des Wechselstromstellers anliegenden Wechselspannung,
- Fig. 5: ein Spannungs-Zeit-Diagramm der am Ausgang des Frequenzumrichters anliegenden Spannung und
- Fig. 6: ein Spannungs-Zeit-Diagramm der am Ausgang der Vorrichtung anliegenden Spannung.

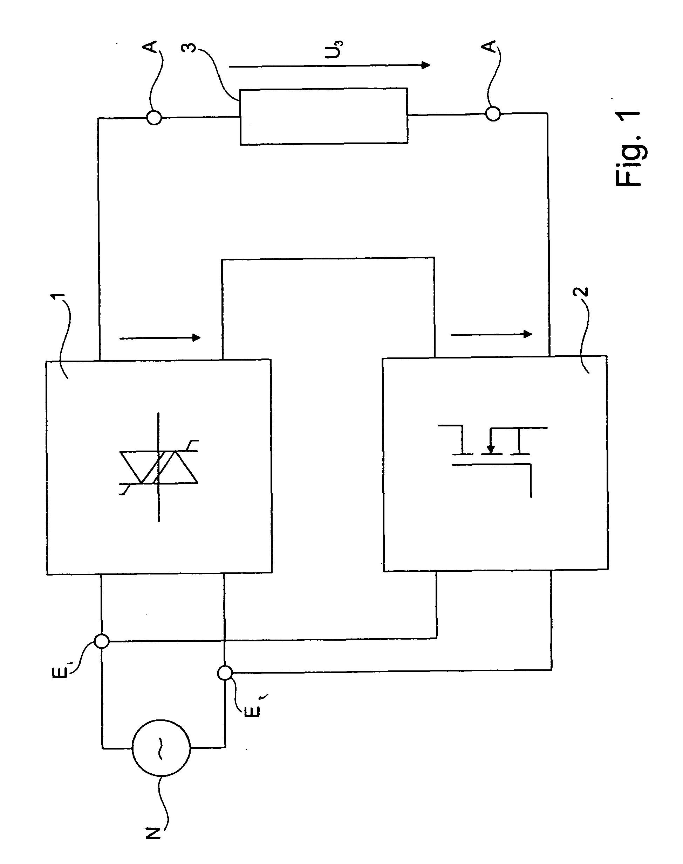

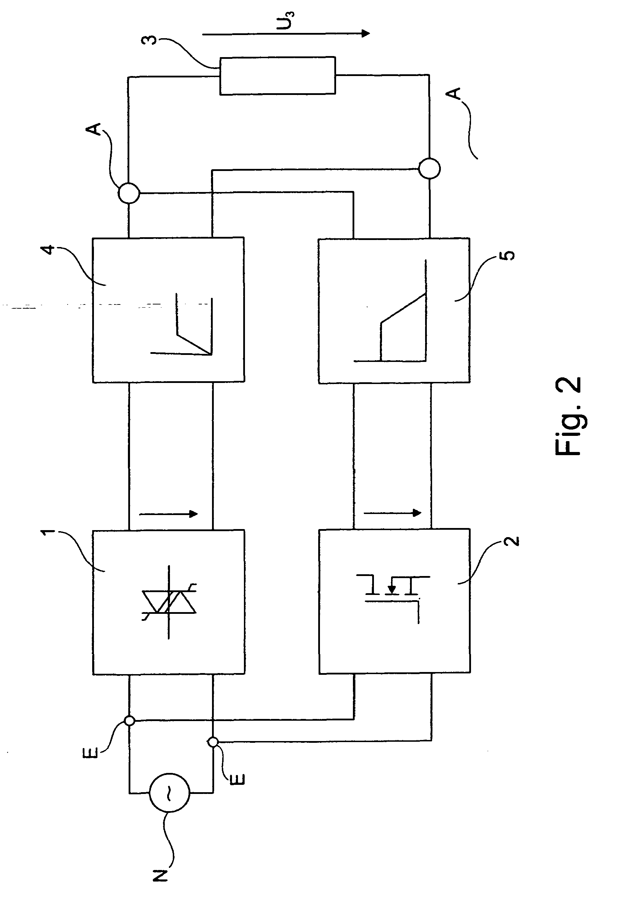

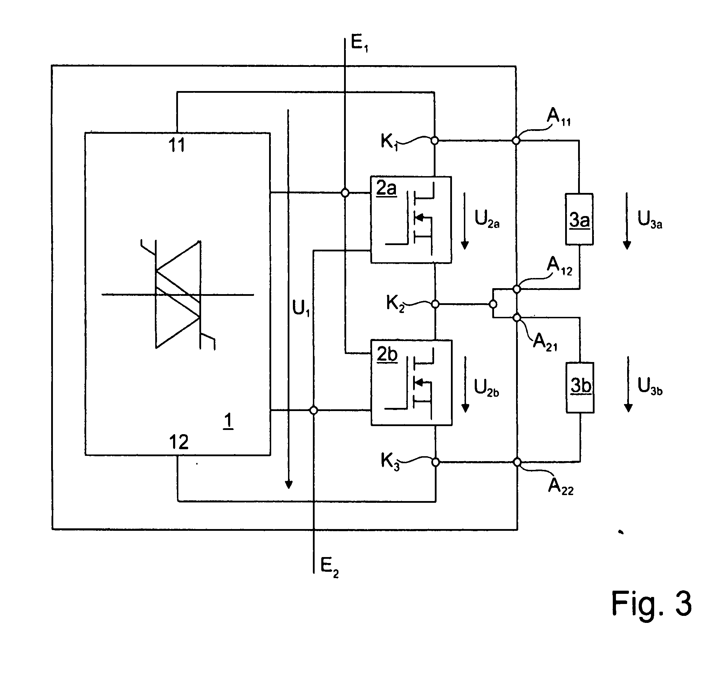

Bei den Darstellungen gemäß der Fig. 1, 2 und 3 handelt es sich um vereinfachte Blockschaltbilder erfindungsgemäßer Vorrichtungen. Dargestellt sind in den Fig. 1, 2 und 3 lediglich die Leistungspfade der erfindungsgemäßen Vorrichtungen. Leitungen für Steuer- oder Regelungssignale sowie Sensorsignale sind in den Fig. 1, 2 und 3 nicht dargestellt. Soweit in der Vorrichtung gemäß der Fig. 1, der Vorrichtung gemäß der Fig. 2 und der Vorrichtung gemäß der Fig. 3 Teile einer gleichen Gattung verwendet sind, tragen diese die gleichen Bezugszeichen.

Die in Fig. 1 dargestellte erfindungsgemäße Vorrichtung zur Stromversorgung eines Siliziumstabs während des Abscheidens von Silizium nach dem Siemens-Verfahren weist einen Eingang E mit zwei Anschlüssen E1, E2 auf. Über den Eingang E ist die Vorrichtung an das Netz N zur Versorgung mit elektrischer Energie angeschlossen. Mit dem Eingang E sind jeweils ein Wechselstromsteller 1 und ein Frequenzumrichter 2 verbunden. Sowohl der Wechselstromsteller 1 als auch der Frequenzumrichter 2 können über den Eingang E elektrische Energie aus dem Energieversorgungsnetz N entnehmen.

Sowohl der Wechselstromsteller 1 als auch der Frequenzumrichter 2 können auf bekannte Art und Weise ausgestaltet sein. Der Wechselstromsteller 1 kann beispielsweise durch eine Schaltungsanordnung von verschiedenen Leistungsthyristoren gebildet sein.

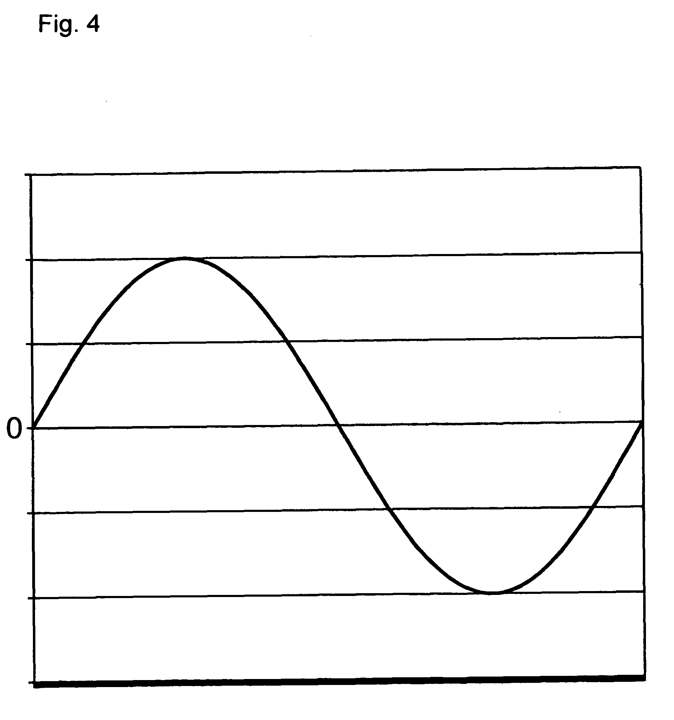

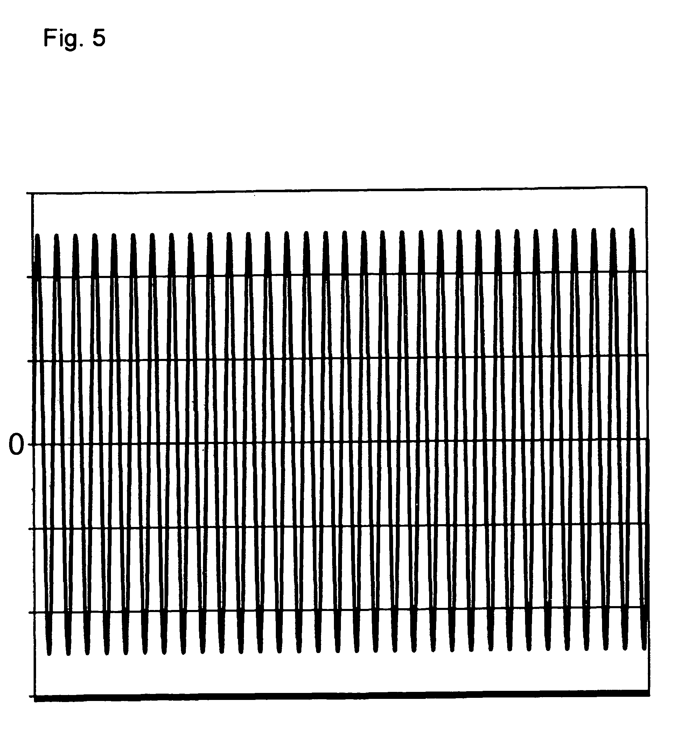

Während der Wechselstromsteller 1 netzgeführt ist, ist der Frequenzumrichter selbstgeführt und stellt an seinem Ausgang eine Spannung bereit, die eine deutlich höhere Frequenz hat als die Spannung, die durch den Wechselstromsteller 1 bereitgestellt wird. Spannungs-Zeit-Diagramme der am Ausgang des Wechselstromstellers 1 beziehungsweise des Frequenzumrichters 2 anliegenden Spannungen sind in den Fig. 4 und 5 dargestellt.

Der Ausgang des Wechselstromstellers 1 und der Ausgang des Frequenzumrichters 2 sind elektrisch in Reihe geschaltet.

Die nicht miteinander verbundenen ausgangsseitigen Anschlüsse des Wechselstromstellers und des Frequenzumrichters sind mit je einem Anschluss des Ausgangs A verbunden, an denen der Siliziumstab 3 angeschlossen ist. An dem Siliziumstab soll sich das durch Dissoziation aus Trichlorsilan gewonnene Silizium abscheiden.

Im Unterschied zu der Vorrichtung, wie sie in der Fig. 1 dargestellt ist, sind bei der Vorrichtung, wie sie in Fig. 2 dargestellt ist, die Ausgänge des Wechselstromstellers 1 und des Frequenzumrichters 2 nicht in Reihe geschaltet. Der Ausgang des Wechselstromstellers 1 ist mit einem Mittel zur Entkopplung mit dem Ausgang A der Vorrichtung verbunden. Der Ausgang des Frequenzumrichters 2 ist in ähnlicher Art und Weise über ein zweites Entkopplungsmittel 5 mit dem Ausgang A der Vorrichtung verbunden.

Die Anordnung aus dem Wechselstromsteller 1 und dem ersten Entkopplungsmittel 4 ist elektrisch parallel zur der Anordnung aus dem Frequenzumrichter 2 und dem zweiten Entkopplungsmittel 5 angeordnet.

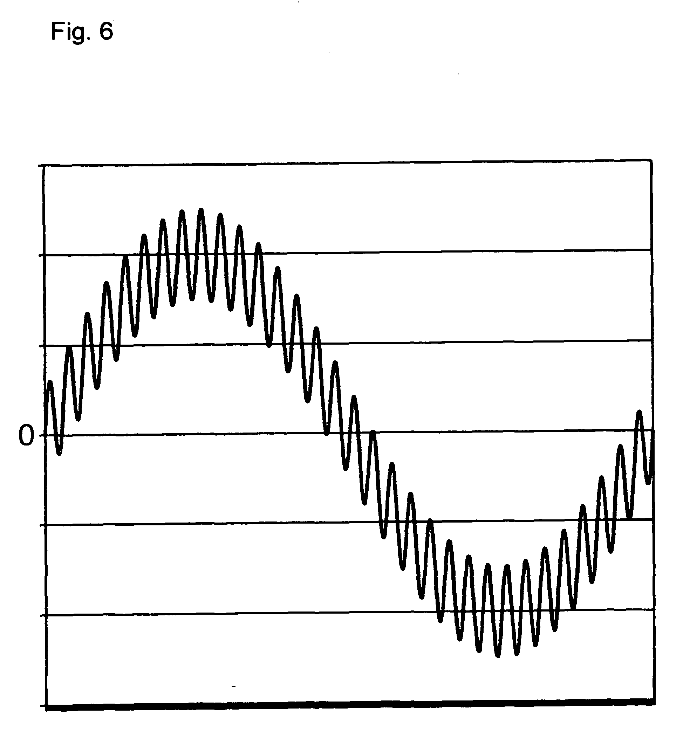

An den Ausgang A ist der Siliziumstab 3 angeschlossen, an dem sich das Silizium abscheiden soll. Sowohl am Ausgang der Vorrichtung gemäß Fig. 1 als auch am Ausgang gemäß der Fig. 2 liegt eine Spannung U3 an, von der ein Spannungs-Zeit-Diagramm in Fig. 6 dargestellt ist. Die Spannung U3 bildet sich durch Überlagerung der Spannungen U1 und U2. Am Ausgang A der Vorrichtung gemäß der Fig. 1 und der Vorrichtung gemäß der Fig. 2 liegt damit eine Spannung an, die einen Strom treibt, dessen Grundfrequenz der Netzfrequenz entspricht und dessen Oberwellenspektrum durch den Frequenzumrichter 2 eingestellt ist. Dieser Strom führt in dem Siliziumstab 3 zu einer homogeneren Stromdichte, als die Verwendung eines Stroms ohne Oberwellenanteil. Während ein Strom, der allein durch die Spannung U1 des Wechselstromstellers 1 getrieben wird, zu einer hohen Stromdichte im Kern des Siliziumstabs 3 führt, bewirkt der Oberwellenanteil, der durch die Spannung U2 des Frequenzumrichters 2 hervorgerufen wird, eine homogenere Verteilung der Stromdichte über den gesamten Querschnitt des Siliziumstabs. Die Einschnürung des Stroms auf den Kern des Siliziumstabs und eine übermäßige Erhitzung des Kerns des Siliziumstabs 3 unterbleibt. Dadurch ist es möglich, den Siemens-Prozess zur Abscheidung von Silizium an dem Siliziumstab mit höheren Temperaturen zu fahren, als bei einer Vorrichtung, bei welcher die Erhitzung des Siliziumstabs allein mit Strom erfolgt, der von einem Wechselstromsteller bereitgestellt wird.

Im Gegensatz zu den Ausführungsbeispielen gemäß der Figuren 1 und 2 weist die erfindungsgemäße Vorrichtung, wie sie in Figur 3 dargestellt ist, einen Wechselstromsteller 1 und zwei Frequenzumrichter 2a, 2b auf. Die Frequenzumrichter 2a, 2b sind identisch aufgebaut und weisen daher identische Ausgangsgrößen auf. Die Frequenzumrichter 2a, 2b werden gegenphasig betrieben, so dass sich an ihren Ausgängen zwar dem Betrag nach die gleiche Spannung einstellt, diese sich jedoch in der Phasenlage unterscheiden, nämlich um 180° gegeneinander verschoben sind.

Die in der Figur 3 dargestellte erfindungsgemäße Vorrichtung weist einen Eingang mit zwei Anschlüssen E1, E2 auf, über den die Vorrichtung mit dem Versorgungsnetz (in Figur 3 nicht dargestellt) verbunden ist. Sowohl der Wechselstromsteller 1 als auch die Frequenzumrichter 2a, 2b sind jeweils mit den Anschlüssen E1, E2 verbunden.
Die an den Ausgängen des Wechselstromstellers 1 und der Frequenzumrichter 2a, 2b zur Verfügung gestellten Spannungen U1 bzw. U2a, U2b werden an drei Knoten K1, K2, K3 miteinander verknüpft.

Die Ausgänge der Frequenzumrichter 2a, 2b sind verkettet, wobei ein erster äußerer Anschluss K1 der Kette mit einem ersten ausgangsseitigen Anschluss eines ersten der beiden Frequenzumrichter 2a, 2b verbunden ist. Ein zweiter ausgangsseitiger Anschluss des ersten Frequenzumrichters ist mit einem inneren Anschluss K2 der Kette verbunden. Mit diesem inneren Anschluss K2 der Kette ist auch ein erster ausgangsseitiger Anschluss eines zweiten der beiden Frequenzumrichter 2a, 2b verbunden. Dessen zweiter ausgangsseitiger Anschluss ist mit einem zweiten äußeren Anschluss K3 verbunden. Die äußeren Anschlüsse K1 und K3 der Kette sind mit ausgangsseitigen Anschlüssen 11, 12 des Wechselstromstellers 1 verbunden.

Der erste äußere Anschluss K1 und der mittlere Anschluss K2 der Kette sind mit einem ersten Ausgang der erfindungsgemäßen Vorrichtung mit den Anschlüssen A11 und A12 verbunden. An diesen ersten Ausgang ist ein erster Siliziumstab 3a angeschlossen.

Der mittlere Anschluss K2 und der zweite äußere Anschluss K3 der Kette aus den beiden Frequenzumrichtern 2a, 2b ist mit einem zweiten Ausgang A21, A22 der Vorrichtung verbunden, an den ein zweiter Siliziumstab 3b angeschlossen ist.

Der Ausgang des ersten Frequenzumrichters 2a und der erste Siliziumstab 3a sind parallel geschaltet. Ebenso sind der Ausgang des zweiten Frequenzumrichters 2b und der zweite Siliziumstab 3b parallel geschaltet. Die Parallelschaltungen sind in Reihe geschaltet und diese Reihenschaltung ist an den Wechselstromsteller 1 angeschlossen.

An den ersten äußeren Anschluss K1, dem mittleren Anschluss K2 und dem zweiten äußeren Anschluss K3 werden die Ausgangsspannungen des Wechselstromstellers und der Frequenzumrichter 2a, 2b miteinander gemischt. Am ersten Ausgang A11, A12 stellt sich ein Gemisch aus der Spannung U2a des ersten Frequenzumrichters 2a und der Spannung U1 des Wechselstromstellers ein. Am zweiten Ausgang A21, A22 stellt sich ein Gemisch aus den Ausgangsspannungen U2b des zweiten Frequenzumrichters und U1 des Wechselstromstellers ein.

Da die Spannungen an den Ausgängen der Frequenzumrichter 2a, 2b dem Betrag nach gleich und gegenphasig sind, fällt zwischen dem Knoten K1 und dem Knoten K3 ausschließlich die Ausgangsspannung des Wechselstromstellers U1 ab, da sich die Spannungen U2a und U2b gegenseitig aufheben. Eine Rückkopplung der Ausgangsspannungen der Frequenzumrichter auf den Wechselstromsteller 1 ist dadurch vermieden.

Durch Kondensatoren (nicht dargestellt) in den Ausgängen der Frequenzumrichter 2a, 2b kann eine Wirkung der Spannung U1 des Wechselstromstellers 1 auf die beiden Frequenzumrichter 2a, 2b vermieden werden. Die Kondensatoren in den Ausgängen der Frequenzumrichter 2a, 2b bilden mit den an den Ausgängen angeschlossenen Lasten, insbesondere deren Ohmschen Anteilen einen Hochpass, der die niedrigen Frequenzen der Spannungen U1 von den Frequenzumrichtern 2a, 2b fernhält. Gegenüber den Vorrichtungen gemäß der Figuren 1 und 2 hat die Vorrichtung gemäß der Figur 3 den Vorteil, dass keine Bauelemente in Reihe zur niederfrequenten Stromversorgung eingesetzt sind. Eine Kopplung zwischen der niederfrequenten Stromversorgung durch den Wechselstromsteller und der mittel- bzw. hochfrequenten Stromversorgung durch die Frequenzumrichter ist vermieden. Ein weiterer Vorteil ist, dass die Frequenzumrichter mit einfachen Mitteln mit einer schon bestehenden Versorgungseinrichtung mit einem Wechselstromsteller kombiniert werden können, um zu einer erfindungsgemäßen Vorrichtung zu gelangen. Eine Nachrüstung von bestehenden Vorrichtung ist daher mit einfachen Mitteln möglich.

## Patentansprüche

1. Vorrichtung zur Stromversorgung wenigstens eines Siliziumstabs (3) während des Abscheidens von Silizium nach dem Siemens-Verfahren, wobei die Vorrichtung
- wenigstens einen Eingang (E) aufweist, der zum Anschließen der Vorrichtung an ein elektrischer Energieversorgungsnetz (N) zur Versorgung mit elektrischer Energie geeignet und eingerichtet ist,
- wenigstens einen Ausgang (A) aufweist, an welchen der wenigstens eine Siliziumstab (3) anschließbar sind,
- wenigstens einen Wechselstromsteller (1) aufweist, der zur Versorgung des wenigstens einen an den wenigstens einen Ausgang (A) angeschlossenen Siliziumstabes (3) mit elektrischen Strom aus dem Energieversorgungsnetz (N) geeignet und eingerichtet ist,
**dadurch gekennzeichnet,**
- **dass** die Vorrichtung ferner wenigstens einen Frequenzumrichter (2) aufweist, der zur Versorgung des wenigstens einen an den wenigstens einen Ausgang (A) angeschlossenen Siliziumstabes (3) mit elektrischen Strom aus dem Energieversorgungsnetz (N) geeignet und eingerichtet, der eine höhere Frequenz hat, als der von dem Wechselstromsteller (1) bereitgestellte Strom,
- **dass** durch die Vorrichtung an dem wenigstens einen Ausgang (A) der Vorrichtung eine aus Spannungsanteilen unterschiedlicher Frequenz gemischte elektrische Spannung bereitstellbar ist und
- **dass** die Vorrichtung Knoten aufweist, an denen die von dem Wechselstromsteller (1) und dem Frequenzumrichter (2) bereitgestellten Spannungen zum Mischen der am Ausgang bereitstellbare Spannung verknüpfbar sind.

2. Vorrichtung nach Anspruch 1 , **dadurch gekennzeichnet, dass** ein Ausgang des wenigstens einen Wechselstromstellers (1), ein Ausgang des wenigstens einen Frequenzumrichters (2) und der Ausgang der Vorrichtung, an den der Siliziumstab anschließbar ist, elektrisch in Reihe angeordnet sind.

3. Vorrichtung nach Anspruch 1 oder 2, **dadurch gekennzeichnet, dass** elektrisch zwischen dem wenigstens einen Wechselstromsteller (1) und dem Ausgang (A) ein erstes Entkopplungsmittel (4) zum Entkoppeln des wenigstens einen Wechselstromstellers (1) von dem wenigstens einen Frequenzumrichter (2) und zwischen dem wenigstens einen Frequenzumrichter (2) und dem Ausgang (A) ein zweites Entkopplungsmittel (5) zum Entkoppeln des wenigstens einen Frequenzumrichters (2) von dem wenigstens einen Wechselstromsteller (1) angeordnet ist.

4. Vorrichtung nach Anspruch 3, **dadurch gekennzeichnet, dass** die Anordnungen aus dem wenigstens einen Wechselstromsteller (1) und dem ersten Entkopplungsmittel (4) einerseits und dem wenigstens einen Frequenzumrichter (2) und dem zweiten Entkopplungsmittel andererseits elektrisch parallel angeordnet sind.

5. Vorrichtung nach Anspruch 1 , **dadurch gekennzeichnet, dass** die Vorrichtung wenigstens ein Paar von Ausgängen für jeweils einen Siliziumstab (3a, 3b) aufweist und wenigsten ein Paar von Frequenzumrichter (2a, 2b) aufweist, das dem Paar von Ausgängen zugeordnet ist.

6. Vorrichtung nach Anspruch 5, **dadurch gekennzeichnet, dass** jeder der beiden Ausgänge eines Paares von Ausgängen mit einem Ausgang eines Frequenzumrichters (2a, 2b) des Paar von Frequenzumrichtern (2a, 2b) verbunden ist

7. Vorrichtung nach Anspruch 6, **dadurch gekennzeichnet, dass** die beiden Frequenzumrichter (2a, 2b) eines Paares von Frequenzumrichtern (2a, 2b) zumindest bezüglich ihrer elektrischen Ausgangsgrößen gleich sind.

8. Vorrichtung nach Anspruch 6 oder 7, **dadurch gekennzeichnet, dass** jeder Frequenzumrichter (2a, 2b) eines Paares einen Ausgang aufweist und dass die Ausgänge eines Paares von Frequenzumrichtern (2a, 2b) eine Kette bilden, in welcher die Ausgänge der Frequenzumrichter (2a, 2b) gegenphasig verkettet sind.

9. Vorrichtung nach Anspruch 8, **dadurch gekennzeichnet, dass** die Kette einen ersten äußeren Anschluss (K1), einen mittleren Anschluss (K2) und einen zweiten äußeren Anschluss (K3) aufweist, wobei der Ausgang eines ersten Frequenzumrichters (2a) des Paares von Frequenzumrichtern (2a, 2b) mit dem ersten äußeren Anschluss (K1) und dem mittleren Anschluss (K2) verbunden ist und der Ausgang eines zweiten Frequenzumrichters (2b) des Paares von Frequenzumrichtern (2a, 2b) mit dem mittleren Anschluss (K2) und dem zweiten äußeren Anschluss (K3) verbunden ist.

10. Vorrichtung nach Anspruch 9, **dadurch gekennzeichnet, dass** ein Ausgang des Wechselstromstellers (1) mit dem ersten äußeren Anschluss (K1) und dem zweiten äußeren Anschluss (K2) verbunden ist.

11. Vorrichtung nach einem der Ansprüche 1 bis 10, **dadurch gekennzeichnet, dass** der wenigstens eine Frequenzumrichter (2) ein Mittelfrequenzumrichter ist.

12. Vorrichtung nach einem der Ansprüche 1 bis 1 1 , **dadurch gekennzeichnet, dass** der wenigstens eine Frequenzumrichter (2) geeignet und eingerichtet ist am Ausgang (A) der Vorrichtung Gemisch aus überlagerten Strömen verschiedener Mittelfrequenzen bereitzustellen.

13. Vorrichtung nach einem der Ansprüche 1 bis 12, **dadurch gekennzeichnet, dass** der wenigstens eine Frequenzumrichter (2) zum Einstellen der Frequenz bzw. der Frequenzen des am Ausgang (A) der Vorrichtung bereitgestellten Stroms bzw. bereitgestellten Ströme geeignet und eingerichtet ist.

14. Vorrichtung nach einem der Ansprüche 1 bis 13, **dadurch gekennzeichnet, dass** die Vorrichtung ein Regelungsmittel aufweist, das zum Einstellen des Verhältnisses der durch den wenigstens einen Wechselstromsteller (1) zu der durch den wenigstens einen Frequenzumrichter (2) bereitgestellten Leistung geeignet und eingerichtet ist.

15. Vorrichtung nach einem der Ansprüche 1 bis 14, **dadurch gekennzeichnet, dass** die Vorrichtung ein Regelungsmittel aufweist, das zum Einstellen der Frequenz bzw. Frequenzen in Abhängigkeit von dem Durchmesser und/oder der Querschnittsfläche des wenigstens einen Siliziumstabs (3) geeignet und eingerichtet ist.

16. Vorrichtung nach einem der Ansprüche 1 bis 15, **dadurch gekennzeichnet, dass** der wenigstens eine Wechselstromsteller (1) ein netzgeführter Wechselstromsteller ist.

17. Verfahren zur Stromversorgung wenigstens eines Siliziumstabs (3) während des Abscheidens von Silizium nach dem Siemens-Verfahren mit einer Vorrichtung nach einem der Ansprüche 1 bis 16.

18. Verfahren nach Anspruch 17, **dadurch gekennzeichnet, dass** das Verhältnis der von dem wenigstens einen Wechselstromsteller (1) zur Verfügung gestellten Leistung zu der von dem wenigstens einen Frequenzumrichter (2) zur Verfügung gestellten Leistung während eines Abscheideprozesses zum Zwecke der Erzeugung einer gleichmäßigen Temperaturverteilung in dem wenigstens einen angeschlossenen Siliziumstab geändert wird.

19. Verfahren nach Anspruch 18, **dadurch gekennzeichnet, dass** die dem wenigstens einen Siliziumstab (3) über den wenigstens einen Frequenzumrichter (2) zugeführte Leistung im Verhältnis zu der über den wenigstens einen Wechselstromsteller (1) zugeführten Leistung während eines Abscheideprozesses größer wird.

## Claims

1. Apparatus for supplying power to at least one silicon rod (3) during the deposition of silicon in accordance with the Siemens process, wherein the apparatus has
- at least one input (E), which is suitable and designed for connecting the apparatus to an electrical energy supply network (N) for supplying electrical energy,
- at least one output (A), to which the at least one silicon rod (3) can be connected,
- at least one AC power controller (1), which is suitable and designed for supplying electrical current from the energy supply network (N) to the at least one silicon rod (3) connected to the at least one output (A),
**characterized**
- **in that** the apparatus further has at least one frequency converter (2), which is suitable and designed for supplying electrical current from the energy supply network (N) to the at least one silicon rod (3) connected to the at least one output (A), said electrical current having a higher frequency than the current provided by the AC power controller (1),
- **in that** an electrical voltage mixed from voltage components of different frequency can be provided by the apparatus at the at least one output (A) of the apparatus, and
- **in that** the apparatus has nodes, at which the voltages provided by the AC power controller (1) and the frequency converter (2) can be combined to mix the voltage which can be provided at the output.

2. Apparatus according to Claim 1, **characterized in that** an output of the at least one AC power controller (1), an output of the at least one frequency converter (2), and the output of the apparatus to which the silicon rod can be connected are arranged electrically in series.

3. Apparatus according to Claim 1 or 2, **characterized in that** a first decoupling means (4) for decoupling the at least one AC power controller (1) from the at least one frequency converter (2) is arranged electrically between the at least one AC power controller (1) and the output (A), and a second decoupling means (5) for decoupling the at least one frequency converter (2) from the at least one AC power controller (1) is arranged electrically between the at least one frequency converter (2) and the output (A).

4. Apparatus according to Claim 3, **characterized in that** the arrangements comprising the at least one AC power controller (1) and the first decoupling means (4), on the one hand, and the at least one frequency converter (2) and the second decoupling means, on the other hand, are arranged electrically in parallel with one another.

5. Apparatus according to Claim 1, **characterized in that** the apparatus has at least one pair of outputs for in each case one silicon rod (3a, 3b) and at least one pair of frequency converters (2a, 2b) which is associated with the pair of outputs.

6. Apparatus according to Claim 5, **characterized in that** each of the two outputs of a pair of outputs is connected to an output of a frequency converter (2a, 2b) of the pair of frequency converters (2a, 2b).

7. Apparatus according to Claim 6, **characterized in that** the two frequency converters (2a, 2b) of a pair of frequency converters (2a, 2b) are identical at least in respect of their electrical output variables.

8. Apparatus according to Claim 6 or 7, **characterized in that** each frequency converter (2a, 2b) of a pair has one output and **in that** the outputs of a pair of frequency converters (2a, 2b) form a chain, in which the outputs of the frequency converters (2a, 2b) are interlinked in phase opposition.

9. Apparatus according to Claim 8, **characterized in that** the chain has a first outer connection (K1), a central connection (K2) and a second outer connection (K3), wherein the output of a first frequency converter (2a) of the pair of frequency converters (2a, 2b) is connected to the first outer connection (K1) and the central connection (K2), and the output of a second frequency converter (2b) of the pair of frequency converters (2a, 2b) is connected to the central connection (K2) and the second outer connection (K3).

10. Apparatus according to Claim 9, **characterized in that** an output of the AC power controller (1) is connected to the first outer connection (K1) and the second outer connection (K3).

11. Apparatus according to one of Claims 1 to 10, **characterized in that** the at least one frequency converter (2) is a medium-frequency converter.

12. Apparatus according to one of Claims 1 to 11, **characterized in that** the at least one frequency converter (2) is suitable and designed for providing a mixture of superimposed currents of different medium frequencies at the output (A) of the apparatus.

13. Apparatus according to one of Claims 1 to 12, **characterized in that** the at least one frequency converter (2) is suitable and designed for adjusting the frequency or frequencies of the current or currents provided at the output (A) of the apparatus.

14. Apparatus according to one of Claims 1 to 13, **characterized in that** the apparatus has a regulation means, which is suitable and designed for adjusting the ratio of the power provided by the at least one AC power controller (1) to the power provided by the at least one frequency converter (2).

15. Apparatus according to one of Claims 1 to 14, **characterized in that** the apparatus has a regulation means, which is suitable and designed for adjusting the frequency or frequencies depending on the diameter and/or the cross-sectional area of the at least one silicon rod (3).

16. Apparatus according to one of Claims 1 to 15, **characterized in that** the at least one AC power controller (1) is a line-fed AC power controller.

17. Method for supplying power to at least one silicon rod (3) during the deposition of silicon in accordance with the Siemens process using an apparatus according to one of Claims 1 to 16.

18. Method according to Claim 17, **characterized in that** the ratio of the power provided by the at least one AC power controller (1) to the power provided by the at least one frequency converter (2) during a deposition process is varied for the purpose of producing a uniform temperature distribution in the at least one connected silicon rod.

19. Method according to Claim 18, **characterized in that** the power supplied to the at least one silicon rod (3) via the at least one frequency converter (2) is greater in relation to the power supplied via the at least one AC power controller (1) during a deposition process.

## Revendications

1. Dispositif d'alimentation électrique d'au moins une barre en silicium (3) pendant la séparation du silicium selon le procédé Siemens, le dispositif
- présentant au moins une entrée (E) qui est conçue et configurée pour le raccordement du dispositif à un réseau d'alimentation en énergie électrique (N) en vue de son alimentation en énergie électrique,
- présentant au moins une sortie (A) à laquelle peut être raccordé l'au moins une barre en silicium (3),
- présentant au moins un gradateur de courant alternatif (1) qui est conçu et configuré pour l'alimentation de l'au moins une barre en silicium (3) raccordé à l'au moins une sortie (A) avec un courant électrique provenant du réseau d'alimentation en énergie (N),
**caractérisé en ce**
- **que** le dispositif présente en outre au moins un convertisseur de fréquence (2) qui est conçu et configuré pour l'alimentation de l'au moins une barre en silicium (3) raccordé à l'au moins une sortie (A) avec un courant électrique provenant du réseau d'alimentation en énergie (N), lequel présente une fréquence supérieure à celle du courant délivré par le gradateur de courant alternatif (1),
- **qu'**une tension électrique mélangée composée de composantes de tension ayant des fréquences différentes peut être délivrée par le dispositif à l'au moins une sortie (A) du dispositif et
- **que** le dispositif présente des noeuds auxquels peuvent être combinées les tensions délivrées par le gradateur de courant alternatif (1) et le convertisseur de fréquence (2) pour le mélange de la tension délivrée à la sortie.

2. Dispositif selon la revendication 1, **caractérisé en ce qu'**une sortie de l'au moins un gradateur de courant alternatif (1), une sortie de l'au moins un convertisseur de fréquence (2) et la sortie du dispositif à laquelle peut être raccordé la barre en silicium sont disposées électriquement en série.

3. Dispositif selon la revendication 1 ou 2, **caractérisé en ce qu'**un premier moyen de découplage (4) est disposé électriquement entre l'au moins un gradateur de courant alternatif (1) et la sortie (A) pour découpler l'au moins un gradateur de courant alternatif (1) de l'au moins un convertisseur de fréquence (2) et un deuxième moyen de découplage (5) est disposé entre l'au moins un convertisseur de fréquence (2) et la sortie (A) pour découpler l'au moins un convertisseur de fréquence (2) de l'au moins un gradateur de courant alternatif (1).

4. Dispositif selon la revendication 3, **caractérisé en ce que** les arrangements composés d'un côté de l'au moins un gradateur de courant alternatif (1) et du premier moyen de découplage (4) et, de l'autre côté, de l'au moins un convertisseur de fréquence (2) et du deuxième moyen de découplage, sont branchés électriquement en parallèle.

5. Dispositif selon la revendication 1, **caractérisé en ce que** le dispositif présente au moins une paire de sorties pour à chaque fois une barre en silicium (3a, 3b) et présente au moins une paire de convertisseurs de fréquence (2a, 2b) qui est associée à la paire de sorties.

6. Dispositif selon la revendication 5, **caractérisé en ce que** chacune des deux sorties d'une paire de sorties est reliée avec une sortie d'un convertisseur de fréquence (2a, 2b) de la paire de convertisseurs de fréquence (2a, 2b).

7. Dispositif selon la revendication 6, **caractérisé en ce que** les deux convertisseurs de fréquence (2a, 2b) d'une paire de convertisseurs de fréquence (2a, 2b) sont identiques au moins du point de vue de leurs grandeurs électriques de sortie.

8. Dispositif selon la revendication 6 ou 7, **caractérisé en ce que** chaque convertisseur de fréquence (2a, 2b) d'une paire présente une sortie et que les sorties d'une paire de convertisseurs de fréquence (2a, 2b) forment une chaîne dans laquelle les sorties des convertisseurs de fréquence (2a, 2b) sont enchaînées en opposition de phase.

9. Dispositif selon la revendication 8, **caractérisé en ce que** la chaîne présente une première borne extérieure (K1), une borne centrale (K2) et une deuxième borne extérieure (K3), la sortie d'un premier convertisseur de fréquence (2a) de la paire de convertisseurs de fréquence (2a, 2b) étant reliée avec la première borne extérieure (K1) et la borne centrale (K2) et la sortie d'un deuxième convertisseur de fréquence (2b) de la paire de convertisseurs de fréquence (2a, 2b) étant reliée avec la borne centrale (K2) et la deuxième borne extérieure (K3).

10. Dispositif selon la revendication 9, **caractérisé en ce qu'**une sortie du gradateur de courant alternatif (1) est reliée avec la première borne extérieure (K1) et la deuxième borne extérieure (K3).

11. Dispositif selon l'une des revendications 1 à 10, **caractérisé en ce que** l'au moins un convertisseur de fréquence (2) est un convertisseur de moyenne fréquence.

12. Dispositif selon l'une des revendications 1 à 11, **caractérisé en ce que** l'au moins un convertisseur de fréquence (2) est conçu et configuré pour délivrer à la sortie (A) du dispositif un mélange de courants superposés ayant des moyennes fréquences différentes.

13. Dispositif selon l'une des revendications 1 à 12, **caractérisé en ce que** l'au moins un convertisseur de fréquence (2) est conçu et configuré pour régler la fréquence ou les fréquences du courant délivré ou des courants délivrés à la sortie (A) du dispositif.

14. Dispositif selon l'une des revendications 1 à 13, **caractérisé en ce que** le dispositif présente un moyen de régulation qui est conçu et configuré pour régler le rapport entre la puissance délivrée par l'au moins un gradateur de courant alternatif (1) et celle délivrée par l'au moins un convertisseur de fréquence (2) .

15. Dispositif selon l'une des revendications 1 à 14, **caractérisé en ce que** le dispositif présente un moyen de régulation qui est conçu et configuré pour régler la fréquence ou les fréquences en fonction du diamètre et/ou de l'aire de section transversale de l'au moins une barre en silicium (3).

16. Dispositif selon l'une des revendications 1 à 15, **caractérisé en ce que** l'au moins un gradateur de courant alternatif (1) est un gradateur de courant alternatif piloté par le réseau.

17. Procédé d'alimentation électrique d'au moins une barre en silicium (3) pendant la séparation du silicium selon le procédé Siemens avec un dispositif selon l'une des revendications 1 à 16.

18. Procédé selon la revendication 17, **caractérisé en ce que** le rapport entre la puissance délivrée par l'au moins un gradateur de courant alternatif (1) et la puissance délivrée par l'au moins un convertisseur de fréquence (2) pendant un processus de séparation est modifié en vue de produire une distribution homogène de la température dans l'au moins une barre en silicium raccordé.

19. Procédé selon la revendication 18, **caractérisé en ce que** la puissance acheminée à l'au moins une barre en silicium (3) par le biais de l'au moins un convertisseur de fréquence (2) est supérieure par rapport à la puissance acheminée par le biais de l'au moins un gradateur de courant alternatif (1) pendant un processus de séparation.
